(19) Europäisches Patentamt / European Patent Office / Office européen des brevets

(11) **EP 3 655 242 B1**

(12) **EUROPEAN PATENT SPECIFICATION**

(45) Date of publication and mention of the grant of the patent:
**07.09.2022 Bulletin 2022/36**

(21) Application number: **18765164.1**

(22) Date of filing: **17.07.2018**

(51) International Patent Classification (IPC):
**B29D 30/36** (2006.01)

(52) Cooperative Patent Classification (CPC):
**B29D 30/36**

(86) International application number:
**PCT/IB2018/055270**

(87) International publication number:
**WO 2019/016687 (24.01.2019 Gazette 2019/04)**

(54) **METHOD FOR CONTROLLING A TYRE BUILDING PROCESS, PLANT FOR TYRE PRODUCTION OPERATING IN ACCORDANCE WITH SAID METHOD AND PROCESSING UNIT CONFIGURED FOR IMPLEMENTING SAID METHOD**

VERFAHREN ZUR STEUERUNG EINES REIFENAUFBAUPROZESSES, ANLAGE ZUR REIFENHERSTELLUNG NACH BESAGTEM VERFAHREN UND PROZESSEINHEIT ZUR IMPLEMENTIERUNG DES BESAGTEN VERFAHRENS

PROCÉDÉ DE COMMANDE D'UN PROCESSUS DE CONSTRUCTION DE PNEUMATIQUE, INSTALLATION DE PRODUCTION DE PNEUMATIQUE FONCTIONNANT SELON LEDIT PROCÉDÉ, ET UNITÉ DE TRAITEMENT CONÇUE POUR LA MISE EN OEUVRE DUDIT PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.07.2017 IT 201700081991**

(43) Date of publication of application:
**27.05.2020 Bulletin 2020/22**

(73) Proprietor: **Pirelli Tyre S.p.A.**
**20126 Milano (IT)**

(72) Inventors:
• **CANTU', Marco**
**I-20126 Milano (IT)**

• **TAVILLA, Antonino**
**I-10036 Settimo Torinese (TO) (IT)**

(74) Representative: **Baroni, Matteo et al**
**Metroconsult S.r.l.**
**Foro Buonaparte, 51**
**20121 Milano (IT)**

(56) References cited:
**WO-A1-2006/033119     WO-A1-2014/049534**
**DE-A1-102007 056 967     US-A1- 2007 137 763**
**US-A1- 2017 001 399     US-A1- 2017 136 823**

## Description

The present invention relates to a method for controlling a tyre building process.

The present invention also relates to a tyre production plant operating in accordance with said method.

The present invention further relates to a processing unit adapted to implement said method, as well as to an electronic unit included in said processing unit.

A tyre for vehicle wheels generally comprises a carcass structure including at least one carcass ply having respectively opposite terminal edges in engagement with respective annular anchoring structures, generally referred to as "bead cores", identified into the regions usually referred to as "beads", the inside diameter of which substantially matches a so-called "fitting diameter" of the tyre for fitting it onto a respective rim. The tyre also comprises a crown structure including at least one belt strip located in a radially external position relative to the carcass ply, and a tread band which is radially external to the belt strip. Between the tread band and the belt strip(s) a so-called "underlayer" of elastomeric material may be interposed, the properties of which are suitable for ensuring a stable union between the belt strip(s) and the tread band. In addition, respective sidewalls of elastomeric material are applied to the side surfaces of the carcass structure, each extending from one of the side edges of the tread band up to the respective annular anchoring structure to the beads. In tyres of the "tubeless" type, the carcass ply is internally coated with a layer of elastomeric material, preferably a butyl-based one, commonly referred to as "liner", which has optimal air tightness properties and extends from one bead to the other.

The term "elastomeric material" refers to a compound comprising at least one elastomeric polymer and at least one reinforcing filler. Preferably, said compound also comprises additives such as, for example, a cross-linking agent and/or a plasticizer. Due to the presence of the cross-linking agent, said material can be cross-linked by heating to form the final product.

The term "semifinished product" refers to a continuous elongated element made of elastomeric material. Preferably, said continuous elongated element comprises one or more reinforcing cords, preferably textile or metallic ones, disposed parallel to each other in the longitudinal direction of the elongated element itself.

The term "elementary semifinished product" refers to a section cut to size of said semifinished product; said elementary semifinished product will be hereafter referred to as "strip-like element".

A "structural component" is meant to be any tyre component assembled or built in band form. Preferably, said band has one or more reinforcing cords (carcass ply(ies), belt strip(s), etc.).

The term "carcass sleeve" refers to a substantially cylindrical structure comprising at least a first carcass ply associated, through respective flaps, with annular anchoring structures.

The term "crown sleeve" refers to a substantially cylindrical structure comprising at least one belt layer and one tread band in a position radially external to said belt layer.

The expression "tyre being processed" refers to a structure formed by one or more structural components of the tyre.

The term "green tyre" refers to a tyre obtained at the end of the building process. In addition to coupling the carcass sleeve to the crown sleeve, the building process may comprise one or more of: at least one rolling step, a deposition step, wherein further semifinished products or specific substances, such as adhesive substances and substances for contaminating, by contact, the moulding and curing units, are deposited onto all or a part of the radially internal surface of the tyre being processed.

The term "finished tyre" refers to a tyre obtained at the end of the moulding and curing process.

In the finished tyre, which has a substantially toroidal conformation, the carcass sleeve corresponds to the carcass structure.

In the finished tyre, which has a substantially toroidal conformation, the crown sleeve corresponds to the crown structure.

The "distance parameter" of a structural component refers to the distance, measured on a radial section, from the centre of the forming drum to the axially and radially internal edge of the structural component.

Document WO 02/05143 A1 describes a method for designing and manufacturing tyres with the aid of an electronic computer and a database containing information. In particular, this document describes a method for designing and manufacturing a tyre with specific performance, according to which structural elements of the tyre are sized by using a set of correlations between said structural elements, associated with desired performance characteristics of said tyre. Within the scope of said designing method, the profile of the moulded tyre cross-section (SCS) is automatically transformed into the profile of the drum tyre cross-section (SCT) by applying predefined transformation rules also taking into account some characteristics of the materials (such as the elasticity of the cords and the plasticity of the compounds), any expansion imposed during the curing step, etc.

Document WO 2009/068933 A1 describes a method for manufacturing tyres for vehicle wheels, wherein a carcass structure, a belt structure and a tread band are built. At least one of said carcass structure, belt structure and tread band comprises a tubular structure. The carcass structure is shaped into a toroidal conformation to associate it with at least said belt structure by exerting a radially deformation force directed from the inside to the outside of said carcass structure. Said method comprises a step of building said tubular structure in such a manner that the profile thereof, along its circumferential extension, has such a starting thickness that the deformed tubular structure following the shaping of the carcass structure has a substantially uniform thickness.

Document WO 2006/033119 discloses a method and an apparatus for manufacturing tyres. According to WO 2006/033119, the constituent elements of a carcass structure of a tyre are formed by laying elementary components on a building support comprising an inflatable bladder set in an inflated condition in which it substantially reproduces the inner configuration of the carcass structure to be obtained. A belt structure carrying a tread band, both produced separately, is coaxially disposed around the carcass structure formed on the building support, and applied thereto following a radial expansion of the inflatable bladder. In a vulcanisation mould the building support is submitted to an over-inflation step to press the tyre against the inner walls of the mould. The circumferential edges of the inflatable bladder are in engagement with respective anchoring flanges with possibility of movement in a radial direction, so as to be submitted to an elastic expansion during the over-inflation step.

The Applicant has observed that at least some of the operations executed for building a green tyre can be carried out by means of suitable machines adapted to execute one or more of the steps of the building process.

The Applicant has observed that, in order to carry out some operations, such machines are set up manually, mainly on the basis of the characteristics of the desired finished tyre and of the experience of the individual operator entrusted with this setup activity.

The Applicant has therefore verified that the human component within the process may cause some problems in terms of quality of the finished product and repeatability.

The Applicant has finally found that, for the building process to be carried out in an accurate and reliable manner, the parameters and/or the commands to be sent to the machines used in said process can be determined by computing parameters describing the carcass sleeve and the crown sleeve and by applying a mathematical model describing a process of shaping said carcass sleeve when the latter is shaped to adhere to the radially inner surface of the crown sleeve, previously positioned in a position radially external thereto, for obtaining the green tyre.

In particular, the Applicant has found that, based on said mathematical model, a parameter associated with the axial length of the green tyre can be determined as a function of the difference between the inner diameter of the crown sleeve and the inner diameter of the carcass sleeve. Such parameter, possibly associated with one or more other parameters, can be supplied to said machines adapted to carry out the building process.

According to a first aspect thereof, the invention relates to a method for controlling a tyre production process according to claim 1, wherein a finished tyre is obtained from a green tyre through at least a moulding and curing process.

The Applicant believes that, in this manner, a green tyre can be built with accuracy and repeatability, thus obtaining, downstream, finished tyres compliant with the respective specifications and having a high level of homogeneity, starting from the same initial data.

According to another aspect thereof, the invention relates to a plant for tyre production according to claim 11.

According to a further aspect thereof, the invention relates to an electronic unit associable with one or more operating apparatuses adapted to build a green tyre according to claim 14.

According to a further aspect thereof, one embodiment of the present invention relates to a processing unit comprising said electronic unit.

Preferably, said processing unit is configured for controlling, as a function of said one or more operating parameters, said one or more apparatuses for the execution of said building process.

Under at least one of the above aspects, the present invention may have at least one of the following preferred features.

Preferably, said building process comprises a shaping process.

Preferably, said one or more operating apparatuses comprise a shaping apparatus configured for shaping said carcass sleeve by inflation and for bringing axial ends of said carcass sleeve near each other.

Preferably, said one or more operating parameters comprise one or more parameters describing a pressure to be applied to said carcass sleeve for said inflation.

Preferably, said one or more operating parameters comprise one or more parameters describing an approach profile of the axial ends of said carcass sleeve.

Preferably, said building process comprises one or more rolling processes.

Preferably, said one or more operating apparatuses comprise one or more rollers and associated drive units.

Preferably, said one or more operating parameters comprise one or more parameters representative of positions to be taken by said one or more rollers.

Preferably, said one or more operating parameters comprise one or more parameters representative of paths to be followed by said one or more rollers.

Preferably, said one or more operating parameters comprise one or more parameters representative of positions to be taken and paths to be followed by said one or more rollers.

Preferably, said building process comprises a deposition process, on a surface of a tyre being processed.

Preferably, said deposition process on a surface of said tyre being processed concerns the deposition of a given substance.

Preferably, said one or more operating apparatuses comprise at least one distribution unit for distributing said/a given substance/semifinished product, and associated drive units.

Preferably, said one or more operating parameters comprise one or more parameters representative of positions to be taken by said at least one distribution unit.

Preferably, said one or more operating parameters comprise one or more parameters representative of paths to be followed by said at least one distribution unit.

Preferably, said building process comprises an extrusion process for obtaining, through respective nozzles, one or more structural components of said green tyre.

Preferably, one or more identification parameters, describing one or more nozzles to be used for said extrusion process, are computed as a function of said second parameters.

Preferably, one or more identification parameters, describing one or more nozzles to be used for said extrusion process, are computed as a function of said third parameters.

Preferably, one or more identification parameters, describing one or more nozzles to be used for said extrusion process, are computed as a function of said first mathematical model.

Preferably, said identification parameters are compared with one or more reference parameters.

Preferably, said one or more reference parameters describe nozzles previously used for making structural components.

Preferably, a confirmation signal is outputted, if said one or more reference parameters correspond to said identification parameters.

Preferably, if said one or more reference parameters do not correspond to said identification parameters, a difference is determined, based on a predefined measurement system, between the nozzles identified by said identification parameters and the nozzles associated with said reference parameters.

Preferably, if said one or more reference parameters do not correspond to said identification parameters, one or more nozzles associated with said reference parameters are determined, for which said difference is lower than a given threshold.

Preferably, if said one or more reference parameters do not correspond to said identification parameters, parameters describing an alternative green tyre obtained by means of said nozzles are computed.

Preferably, if said one or more reference parameters do not correspond to said identification parameters, an output describing said alternative green tyre is generated.

Preferably, a processor is activated for computing, as a function of said second parameters, one or more output parameters for the execution of a manufacturing process on said green tyre.

Preferably, a processor is activated for computing, as a function of said third parameters, one or more output parameters for the execution of a manufacturing process on said green tyre.

Preferably, a processor is activated for computing, as a function of said first mathematical model, one or more output parameters for the execution of a manufacturing process on said green tyre.

Preferably, said one or more output parameters comprise the axial dimension of said green tyre.

Preferably, said manufacturing process comprises a moulding and curing process.

Preferably, said carcass sleeve comprises a first anti-abrasive layer.

Preferably, said carcass sleeve comprises a liner.

Preferably, said carcass sleeve comprises an underliner.

Preferably, said carcass sleeve comprises a second ply.

Preferably, said carcass sleeve comprises at least one edge.

Preferably, said carcass sleeve comprises at least a sidewall portion.

Preferably, said carcass sleeve comprises a second anti-abrasive layer.

Preferably, said crown sleeve comprises an under-belt layer.

Preferably, said crown sleeve comprises a zero-degree layer.

Preferably, said crown sleeve comprises a conductive insert.

Preferably, said crown sleeve comprises a tread band underlayer.

Preferably, for determining said first parameters, said first parameters are read from said memory.

Preferably, for determining said first parameters, said first parameters are received.

Preferably, said first parameters are progressively entered by a user during a data entry step.

Preferably, during said data entry step, said first parameters comprise parameters already entered and parameters yet to be entered.

Preferably, said processor is activated to provide suggested values for said parameters yet to be entered.

Preferably, said suggested values are determined as a function of said parameters already entered.

Preferably, said processor is activated to display on a display, associated with said processor, a graphic representation of said carcass sleeve on the basis of said second parameters.

Preferably, said processor is activated to display on a display, associated with said processor, a graphic representation of said crown sleeve on the basis of said third parameters.

Preferably, said processor is activated to display on a display, associated with said processor, a graphic representation of said green tyre on the basis of said one or more operating parameters.

Preferably, the second parameters used for said graphic representation are determined as a function of said parameters already entered.

Preferably, the second parameters used for said graphic representation are determined as a function of said suggested values.

Preferably, the third parameters used for said graphic representation are determined as a function of said parameters already entered.

Preferably, the third parameters used for said graphic representation are determined as a function of said suggested values.

Preferably, said one or more operating parameters used for said graphic representation are determined as a function of said parameters already entered.

Preferably, said one or more operating parameters used for said graphic representation are determined as a function of said suggested values.

Preferably, said first parameters comprise a fitting parameter.

Preferably, said first parameters comprise one or more parameters representative of the type of structural components of the finished tyre.

Preferably, said first parameters comprise one or more parameters representative of the number of structural components, for each type, of the finished tyre.

Preferably, said first parameters comprise a parameter representative of a height of a filling insert of the finished tyre.

Preferably, said first parameters comprise an elongation parameter representative of an increment to be applied to a respective positioning parameter in order to obtain an actual length of a corresponding structural component in said finished tyre.

Preferably, said first parameters comprise a width parameter representative of a dimension, measured in the axial direction, of a tread band of said finished tyre.

Preferably, said second parameters comprise a positioning parameter for a forming drum used for building the green tyre.

Preferably, said first parameters comprise a distance parameter for each one of the structural components of the carcass sleeve.

Preferably, said processor is activated to retrieve a second mathematical model from said memory.

Preferably, said processor is activated to compute said second parameters starting from said first parameters by applying said second mathematical model.

Preferably, said processor is activated to retrieve a third mathematical model from said memory.

Preferably, said processor is activated to compute said third parameters starting from said first parameters by applying said third mathematical model.

Further features and advantages will become more apparent in the light of the following detailed description of a preferred but non-limiting embodiment of the invention. Reference will be made in the following description to the annexed drawings, which are also provided by way of illustrative and non-limiting example, wherein:

- Figure 1 schematically shows a partial section, in a radial plane, of a finished tyre that can be obtained on the basis of the present invention;
- Figure 2 schematically shows a first apparatus that can be controlled in accordance with the method of the invention;
- Figure 3 schematically shows a second apparatus that can be controlled in accordance with the method of the invention;
- Figure 4 schematically shows a third apparatus that can be controlled in accordance with the method of the invention;
- Figure 5 schematically shows a block diagram representative of a plant, a processing unit and an electronic unit according to the invention.

With reference to the annexed drawings, 1 designates as a whole a finished tyre that can be taken into consideration within the frame of the present invention.

The finished tyre 1 comprises a carcass structure 2 comprising at least one carcass ply 3 having respectively opposite end flaps in engagement with respective annular anchoring structures 4, possibly associated with elastomeric fillers 4a, integrated into the regions 5 usually identified as "beads". The carcass ply 3 comprises a plurality of textile or metallic reinforcing cords arranged parallel to one another and at least partially coated with a layer of elastomeric material.

With the carcass structure 2 a belt structure 6 is associated, which comprises one or more belt layers, radially superimposed on each other and relative to the carcass ply 3, and having reinforcing cords, typically metallic ones. Such reinforcing cords may be cross-oriented relative to the circumferential development direction of the tyre 1.

In a position radially external to the belt structure 6, a tread band 7 of elastomeric material is applied, along with other semifinished products constituting the tyre 1.

In addition, respective sidewalls 8 of elastomeric material are applied, in an axially external position, to the side surfaces of the carcass structure 2, each one extending from one of the side edges of the tread band 7 up to the respective annular anchoring structure for anchoring to the beads 5.

A radially internal surface of the tyre is also preferably coated with a layer of elastomeric material, called liner 9, which is substantially impermeable to air.

Preferably, the finished tyre 1 is described by first parameters P1.

Preferably, the first parameters P1 comprise a fitting parameter.

Preferably, the first parameters P1 comprise one or more parameters representative of the type of structural components of the finished tyre. By way of example, these parameters may indicate if the structural components of the finished tyre must be made by juxtaposition/superimposition of strip-like elements, by progressive deposition of semifinished products, or by direct extrusion in ply form.

Preferably, the first parameters P1 comprise one or more parameters representative of the number of structural components, for each type, of the finished tyre. By way of example, these parameters may indicate the number of plies or other components of the tyre.

Preferably, the first parameters P1 comprise a parameter representative of a height of a filling insert of the finished tyre.

Preferably, the first parameters P1 comprise an elongation parameter representative of an increment to be applied to a respective positioning parameter in order to obtain an actual length of a corresponding structural component in said finished tyre.

Preferably, said first parameters P1 comprise a width parameter representative of a dimension, measured in the axial direction, of a tread band of said finished tyre.

The first parameters P1 constitute the so-called "recipe" that identifies the most important structural characteristics of the finished tyre 1.

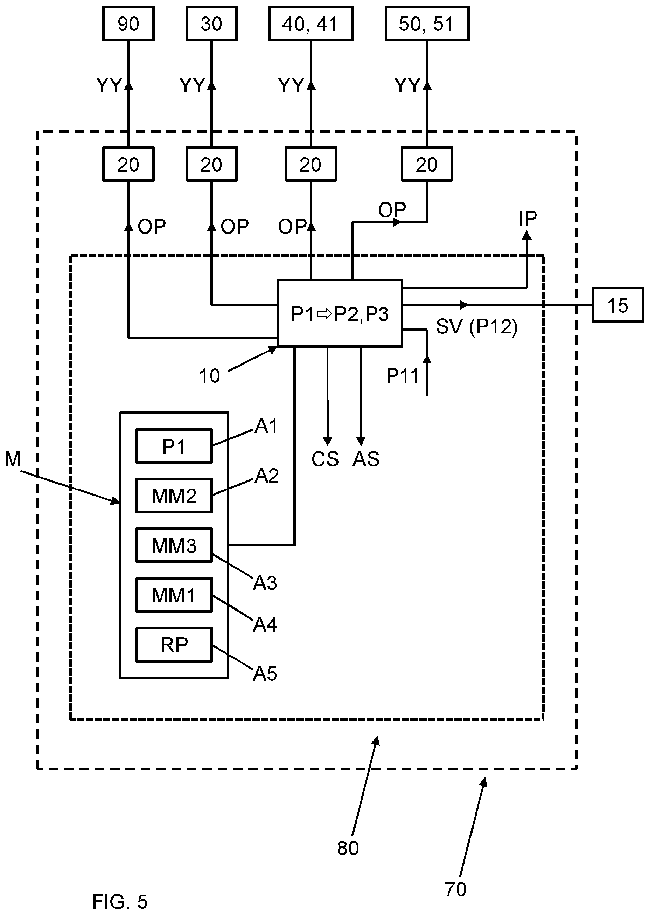

In one embodiment, the first parameters P1 are read, through a processor 10 (Figure 5), from a memory M into which they were previously stored. The memory M may be connected directly to the processor 10, e.g. integrated into the same electronic apparatus. The memory M may also be external to the electronic apparatus that includes the processor 10. In this case, the connection between the memory M and the processor 10 may be either local or remote.

In one embodiment, the first parameters P1 are sent to the processor 10. Such first parameters P1 may be, for example, determined or acquired by a different electronic device, and then sent from the latter to the processor 10.

In one embodiment, the first parameters P1 are progressively entered by a user during a data entry step.

Preferably, during said data entry step the first parameters P1 comprise parameters already entered P11 and parameters yet to be entered P12. In other words, since they are entered by a user, the first data P1 are entered in succession, one after the other. At any instant, therefore, there will be first parameters P1 that have already been entered by the user (i.e. the parameters already entered P11) and first parameters P1 that have yet to be entered (i.e. the parameters yet to be entered P12).

The processor 10 is preferably configured for providing suggested values SV for the parameters yet to be entered P12.

Such suggested values SV may be determined as a function of the parameters already entered P11.

In practice, for entering the first parameters P1 a user interface may be provided, e.g. in the form of a mask in which, for each first parameter P1, it is possible to enter a respective value. Once one or more first parameters P1 have been entered, the processor may provide suggested values SV for the remaining parameters. Such suggested values SV may be based on preset values, which are acceptable in general terms, and/or on the parameters already entered. In this manner, the user can be guided towards the definition of a finished tyre 1 for which, to a certain extent, performance and reliability will be ensured.

According to one aspect of the invention, the processor 10 computes second parameters P2 as a function of the first parameters P1.

The second parameters P2 describe a carcass sleeve 100 to be used for building a green tyre, which in turn will allow obtaining, through a curing and moulding process, the finished tyre 1.

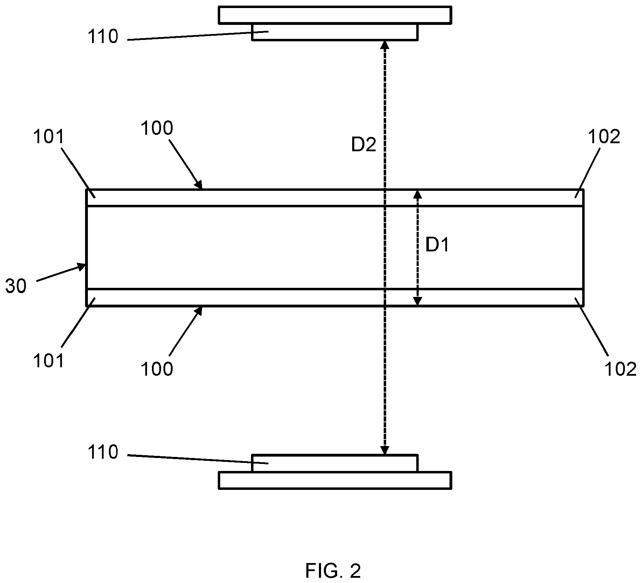

Preferably, the carcass sleeve 100 (schematized in Figure 2), which has a substantially cylindrical shape, has said at least one carcass ply 3 with respectively opposite end flaps in engagement with said respective annular anchoring structures 4, possibly associated with said elastomeric fillers 4a, and comprises at least one of: a first anti-abrasive layer, a liner, an underliner, a second ply, at least one edge, at least a sidewall portion, and a second anti-abrasive layer.

Preferably, the second parameters P2 are obtained as a function of a mathematical model (hereafter referred to as second mathematical model MM2) and, as aforesaid, of the first parameters P1.

The second mathematical model MM2 may be based on the specification of the finished tyre, i.e. on the technologic and geometric characteristics thereof: single-ply or dual-ply tyre, bead wire type, presence or absence of sidewall inserts for run-flat operation (run-flat tyre), presence or absence of a self-sealing layer (self-sealing tyre), presence and type of any reinforcements, geometrical dimensions of the tyre (e.g. fitting diameter, maximum axial dimension, sidewall height), etc.

Advantageously, the second mathematical model MM2 can be retrieved by the processor 10 from the memory M, and in particular from a respective second area A2 of said memory M.

Preferably, the second parameters P2 comprise at least one parameter describing an outer diameter D1 of the carcass sleeve 100.

Preferably, the second parameters P2 comprise a positioning parameter for a forming drum used for building the green tyre.

Preferably, the second parameters P2 comprise a distance parameter for each one of the structural components of the carcass sleeve 100.

As a function of the first parameters P1, the processor 10 also computes third parameters P3.

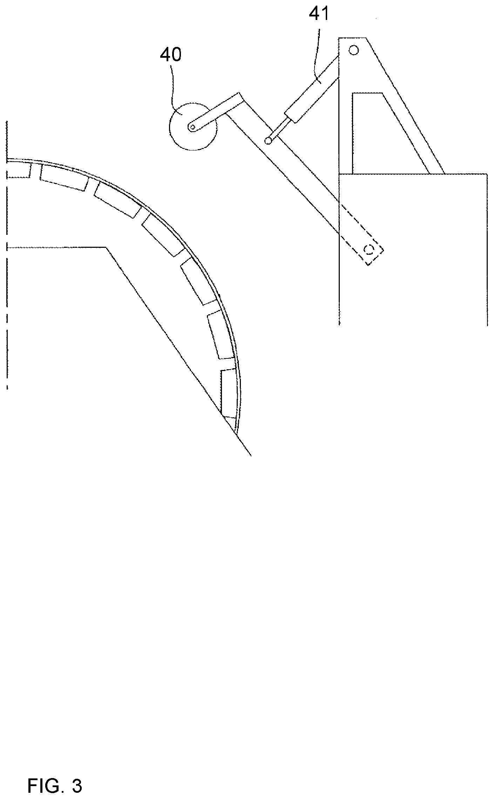

The third parameters P3 describe a crown sleeve 110 (Figure 3) to be used for building a green tyre, which in turn will allow obtaining, through a curing and moulding process, the finished tyre 1.

Preferably, the substantially cylindrical crown sleeve 110 has said one or more belt layers and said tread band 7, and comprises at least one of: an underbelt layer, a zero-degree layer, a conductive insert, and a tread band underlayer.

Preferably, the third parameters P3 are obtained as a function of a mathematical model (hereafter referred to as third mathematical model MM3) and, as aforesaid, of the first parameters P1.

Advantageously, the third mathematical model MM3 can be retrieved by the processor 10 from the memory M, and in particular from a respective third area A3 of said memory M.

Preferably, the third parameters P3 comprise at least one parameter describing an inner diameter D2 of the crown sleeve 110.

The third mathematical model MM3 is preferably based on the determination of the solid/void ratio in the pattern of the tread band and on the resulting computation of the characteristics and/or dimensions of a tread band in the green state, which, when subjected to a moulding and curing process, will show the desired tread pattern.

Preferably, during the green tyre building process, the crown sleeve 110 is associated with said carcass sleeve 100.

The processor 10 is configured for retrieving, from the memory M, and in particular from a fourth area A4 thereof, a first mathematical model MM1 describing the green tyre building process.

During said process, the carcass sleeve 100 is so shaped as to adhere to the radially inner surface of the crown sleeve.

Preferably, the shaping of the carcass sleeve 100 is essentially carried out in two steps:

a step of inflating the carcass sleeve 100, aimed at increasing the radial dimension of the latter, until it reaches the radially inner surface of the crown sleeve 110;
a step of bringing the axial ends of the carcass sleeve 100 near each other.

Advantageously, the first mathematical model MM1 puts the axial dimension of the green tyre in relation with the difference between the inner diameter D2 of the crown sleeve 110 and the outer diameter D1 of the carcass sleeve 100.

In other words, the first mathematical model MM1 allows correlating the radial deformation of the carcass sleeve 100 with the axial deformation of the same carcass sleeve 100.

The first mathematical model MM1 may, for example, be based on the following relation:

$$\rho \bullet y = constant$$

where, for each point of the section of the tyre being processed in a radial plane (i.e. in a plane containing the axis of rotation of the tyre being processed), ρ represents the radius of curvature, and y represents the distance from a straight line parallel to the axis of rotation of the tyre being processed and tangent to the radially internal points of the beads of the same.

On the basis of the second parameters P2, third parameters P3 and first mathematical model MM1, the processor 10 is configured for computing one or more operating parameters OP.

The operating parameters OP are then used for the execution of the green tyre building process.

In particular, the operating parameters OP are acquired by means of a control device 20; the latter is configured for controlling one or more operating apparatuses 30; 40, 41; 50, 51; for the execution of the building process.

In one embodiment, each operating apparatus is controlled by a respective control device 20.

Each control device 20 may consist of, comprise, or be included in a PLC suitably programmed for the operations that the respective operating apparatus will have to carry out.

As will become more apparent below, each control device 200 can receive the operating parameters OP from an electronic unit 80.

Figure 5 schematically shows a plant for tyre production, comprising the operating apparatuses 30; 40, 41; 50, 51; the respective control devices 20, and the electronic unit 80.

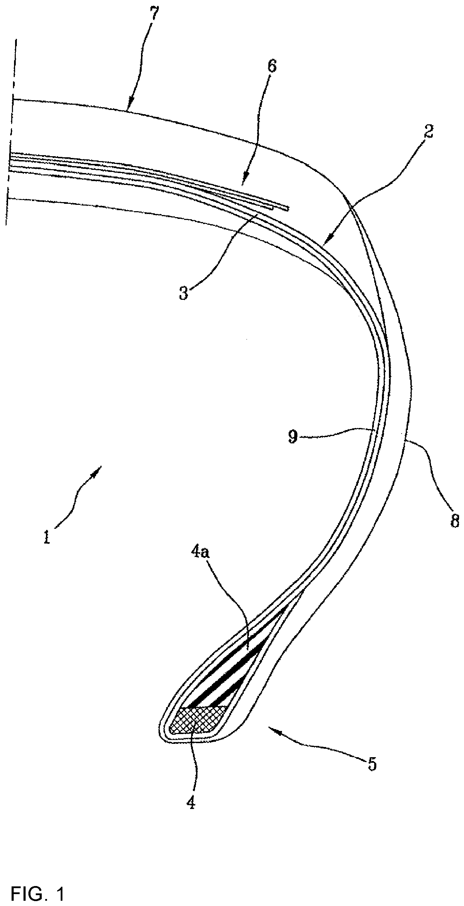

The electronic unit 80 and the control devices 20 may constitute a processing unit 70, also schematically shown in Figure 1.

Through the processing unit 70, the various operating apparatuses 30; 40, 41; 50, 51; receive control signals YY useful for the execution of the building process.

Preferably, the operating parameters OP comprise at least one parameter associated with the axial dimension of the green tyre.

More in detail, the building process comprises, as aforementioned, a shaping process. The shaping process can be carried out by a shaping apparatus 30 (schematized in Figure 2), configured for executing the above-described operations. In particular, the shaping apparatus 30 is configured for shaping the carcass sleeve 100 by inflating it and by bringing the axial ends 101, 102 near each other.

With reference to the shaping apparatus 30, the operating parameters OP may comprise one or more parameters describing an inflation pressure to be applied to the carcass sleeve 100. In particular, the operating parameters OP may describe an inflation profile, i.e. pressure values to be applied, at given time instants and/or intervals, for the purpose of shaping the carcass sleeve 100.

With reference to the shaping apparatus 30, the operating parameters OP may comprise one or more parameters describing an approach profile of the axial ends 101, 102 of the carcass sleeve 100. This profile indicates the positions that the axial ends 101, 102 will take during the shaping process.

In one embodiment, the shaping of the carcass sleeve occurs in a plurality of separate steps, e.g. four separate steps. For each one of them, the operating parameters OP preferably specify the pressure to be applied and the positions that the axial ends 101, 102 must take.

In one embodiment, the building process comprises one or more rolling processes. The operating apparatuses may thus comprise one or more rollers 40 and associated drive units 41 (schematized in Figure 3).

The operating parameters OP may then comprise one or more parameters representative of positions to be taken and/or paths to be followed by said one or more rollers 40.

In one embodiment, the building process comprises a deposition process, executed on a surface of the tyre being processed. Said deposition process may concern, for example, a substance suitable for preventing excessive adhesion of the green tyre to parts of the curing apparatus, typically the curing chambers. The substance is deposited onto a green tyre during one of the final steps of the shaping process, so that it will then be transferred by contact onto said parts of the curing apparatus.

The deposited substance may also be an adhesive substance, useful for the application of labels or other similar items onto the surface of the green tyre, or a substance/additional semifinished product useful for different purposes.

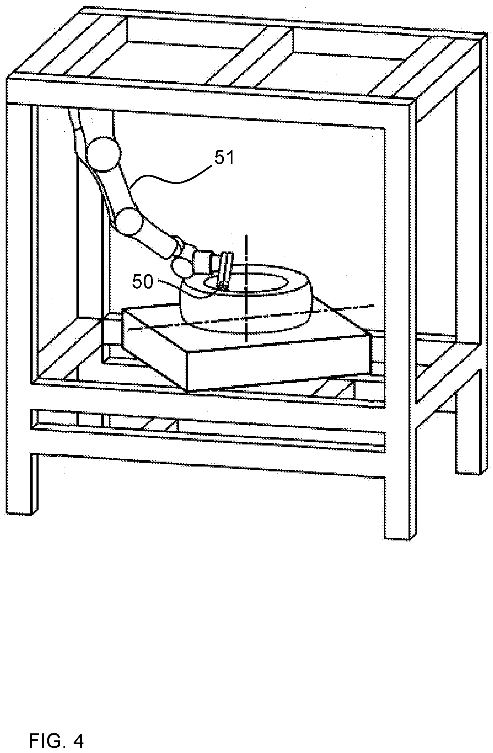

The operating apparatuses may then comprise at least one distribution unit 50 for distributing said substance onto the green tyre, and associated drive units 51 (Figure 4).

In one embodiment, the drive units 51 comprise a robotized arm or another automatically controlled mobile support. The operating parameters OP may comprise one or more parameters representative of positions to be taken and/or paths to be followed by said at least one distribution unit 50. The operating parameters OP can be used for controlling the drive units 51, so as to guide the at least one distribution unit into the desired positions.

In one embodiment, the building process comprises an extrusion process for obtaining one or more structural components of the green tyre. Such structural components may be extruded, through suitable nozzles, as a ply or a semifinished product or a strip-like element.

The processor 10 is preferably configured for computing, on the basis of the second parameters P2, third parameters P3 and first mathematical model MM1, one or more identification parameters IP describing the nozzle(s) to be used in the extrusion process.

The identification parameters IP may be, for example, identification codes associated with respective nozzle types. In addition or as an alternative, the identification parameters may directly express dimensions and/or other structural characteristics and/or functional characteristics of the respective nozzles.

In practical terms, each set of one or more identification parameters preferably identifies, in a univocal manner, one nozzle to be used for making a respective structural component.

In one embodiment, the memory M stores one or more first reference parameters RP. Such reference parameters RP may be stored in a fifth area A5 of said memory M.

The reference parameters RP describe nozzles previously used for making structural components of other tyres. In practice, the reference parameters RP are representative of nozzles used in the past and currently available, e.g. stored in the warehouse.

The processor 10 can thus compare the computed identification parameters with said reference parameters RP.

If the identification parameters and the reference parameters RP match, e.g. are equal, it will be possible to use a nozzle already used in the past, without the need for building or providing new nozzles.

In this case, the processor 10 will generate a confirmation signal CS representative of this favourable circumstance.

In one embodiment, the confirmation signal CS may contain data useful for identifying and/or retrieving the available nozzle.

If the identification parameters and the reference parameters RP do not match, it will nevertheless be evaluated the possibility of using a nozzle that is already available, although different from the specified one.

To this end, if said one or more reference parameters RP do not correspond to the identification parameters, the processor 10 will determine, on the basis of a predefined measurement system, a difference between the nozzles identified by the identification parameters and the nozzles associated with the reference parameters RP.

In other words, the processor 10 will make a comparison between the desired nozzles and the available nozzles.

If one nozzle among those available is sufficiently similar to the desired one, i.e. if said difference is smaller than a predefined threshold, then said available nozzle will be virtually selected.

The processor 10 will then take care of computing parameters describing an alternative green tyre, obtained by means of the selected nozzle, and generating an output describing said alternative green tyre.

Said output may be, for example, displayed on a display 15 associated with the processor 10, so that the personnel in charge can evaluate this alternative proposal and decide whether to actually employ a nozzle already available, but different from the identified one, or to prepare a new one.

Preferably, the first mathematical model MM1 can also be used for verifying the acceptability of the first parameters P1 entered. In fact, as aforesaid, the first mathematical model MM1 describes the shaping process, wherein the radially outer surface of the carcass sleeve 100 must come to adhere to the radially inner surface of the crown sleeve 110. In the event that, during this modelling, the shaping operation is not successful (e.g. because the carcass sleeve 100 has dimensions that prevent it from reaching the crown sleeve 110), then the processor 10 will generate an alarm signal AS for calling the operator's attention to this circumstance.

Preferably, the processor 10 is configured for computing one or more output parameters Pout.

The output parameters Pout are computed as a function of the second parameters P2, third parameters P3 and first mathematical model MM1.

The output parameters Pout are used for the execution of a manufacturing process on the green tyre. In other words, the output parameters Pout are used for working on the green tyre after the completion of the building process.

By way of example, said manufacturing process may comprise a moulding and curing process, executed through a suitable curing station 90.

Advantageously, the output parameters Pout may comprise the axial dimension of the green tyre. This makes it possible, for example, to move the green tyre correctly within the curing station, as well as handling the units included in this station without hitting (and potentially damaging) the green tyre itself.

In one embodiment, the curing station 90 is associated with a respective control device 20, which receives the output parameters Pout from the processor 10 and controls the curing station 90 accordingly.

In one embodiment, the processor 10 cooperates with the display 15 to display the results of the processing carried out and to make them available to the operators in charge.

For example, a graphic representation of the carcass sleeve 100, based on the second parameters P2, may be displayed.

For example, a graphic representation of the crown sleeve 110, based on the third parameters P3, may be displayed.

For example, a graphic representation of the green tyre, based on the operating parameters OP, may be displayed.

Preferably, two or more of said graphic representations are displayed.

In one embodiment, one or more of said graphic representations can be displayed while entering the first parameters P1. In particular, as aforesaid, at any instant of the step of entering the first parameters P1 there are some parameters already entered P11 and some parameters yet to be entered P12. The processor 10 may provide suggested values SV for the parameters yet to be entered P12. The processor 10 is therefore configured for determining, during the entry of the first parameters P1, the second parameters P2 and/or the third parameters P3 and/or the output parameters OP on the basis of the parameters already entered P11 and of the suggested values SV for the parameters yet to be entered P12. In this manner, graphic representations are displayed which correspond to the values that the user has already entered, combined with values that the processor 10 considers to be acceptable/advisable. The graphic representations can then be progressively updated on the basis of the other first parameters P1 subsequently entered by the user.

In one embodiment, the areas A1-A5 of the memory M can be integrated into a single physical device.

In a different embodiment, one or more areas A1-A5 of the memory M may be separate from the others, i.e. implemented in respective physical devices distinct from one another. Nevertheless, the processor 10 will still be equipped with the necessary connectivity (wired and/or wireless; short range and/or long range) for appropriately interfacing with the memory areas A1-A5.

## Claims

1. Method for controlling a tyre production process, wherein a finished tyre is obtained from a green tyre through at least a moulding and curing process, comprising:

   determining first parameters (P1) describing said finished tyre;
   activating a processor (10) for computing, as a function of said first parameters (P1), second parameters (P2) describing a carcass sleeve (100) and third parameters (P3) describing a crown sleeve (110), said carcass sleeve (100) and said crown sleeve (110) being used for building said green tyre;
   wherein said second parameters (P2) comprise at least one parameter representative of an outer diameter (D1) of said carcass sleeve (100);
   wherein said third parameters (P3) comprise at least one parameter representative of an inner diameter (D2) of said crown sleeve (110);
   through said processor (10), retrieving from a memory (M) associated with said processor (10) a first mathematical model (MM1) describing a process of shaping said carcass sleeve (100) when the latter is shaped to adhere to the radially inner surface of said crown sleeve (110), for obtaining said green tyre;
   activating said processor (10) for computing, as a function of said second parameters (P2), said third parameters (P3) and said first mathematical model (MM1), one or more operating parameters (OP) for the execution of a building process for building said green tyre;

wherein said one or more operating parameters (OP) comprise at least one parameter associated with an axial dimension of said green tyre;

wherein said first mathematical model (MM1) puts the axial dimension of said green tyre in relation with a difference between the inner diameter (D2) of said crown sleeve (110) and the outer diameter (D1) of said carcass sleeve (100);

through a control device (20), acquiring said one or more operating parameters (OP) and controlling one or more operating apparatuses (30; 40, 41; 50, 51) for executing said building process.

2. Method according to claim 1, wherein said building process comprises a shaping process, said one or more operating apparatuses comprising a shaping apparatus (30) configured for shaping said carcass sleeve (100) by inflation and for bringing axial ends (101, 102) of said carcass sleeve (100) near each other.

3. Method according to claim 2, wherein said one or more operating parameters (OP) comprise one or more parameters describing a pressure to be applied to said carcass sleeve (100) for said inflation and one or more parameters describing an approach profile of the axial ends (101, 102) of said carcass sleeve (100).

4. Method according to any one of the preceding claims, wherein said building process comprises an extrusion process for obtaining, through respective nozzles, one or more structural components of said green tyre

the method comprising computing, as a function of said second parameters (P2), said third parameters (P3) and said first mathematical model (MM1), one or more identification parameters (IP) describing one or more nozzles to be used for said extrusion process
the method comprising:

➢ comparing said identification parameters (IP) with one or more reference parameters (RP), said one or more reference parameters (RP) describing nozzles previously used for making structural components;
➢ outputting a confirmation signal (CS), if said one or more reference parameters (RP) correspond to said identification parameters (IP).

5. Method according to claim 4, comprising, if said one or more reference parameters (RP) do not correspond to said identification parameters (IP):

➢ determining, based on a predefined measurement system, a difference between the nozzles identified by said identification parameters (IP) and the nozzles associated with said reference parameters (RP);
➢ determining one or more nozzles associated with said reference parameters (RP), for which said difference is lower than a given threshold;
➢ computing parameters describing an alternative green tyre obtained by means of said determined nozzles;
➢ generating an output describing said alternative green tyre.

6. Method according to any one of the preceding claims, comprising activating said processor (10) for computing, as a function of said second parameters (P2), said third parameters (P3) and said first mathematical model (MM1), one or more output parameters (Pout) for the execution of a manufacturing process on said green tyre

wherein said one or more output parameters (Pout) comprise the axial dimension of said green tyre
wherein said manufacturing process comprises a moulding and curing process.

7. Method according to any one of the preceding claims, wherein determining said first parameters comprises receiving said first parameters (P1)

wherein said first parameters (P1) are progressively entered by a user during a data entry step.
wherein, during said data entry step, said first parameters (P1) comprise parameters already entered (P11) and parameters yet to be entered (P12), wherein said method comprises activating said processor (10) to provide suggested values (SV) for said parameters yet to be entered (P12), said suggested values (SV) being determined as a function of said parameters already entered (P11).

8. Method according to any one of the preceding claims, wherein said first parameters (P1) comprise one or more of: a fitting parameter; one or more parameters representative of the type of structural components of the finished tyre; one or more parameters representative of the number of structural components, for each type, of the finished tyre; a parameter representative of a height of a filling insert of the finished tyre; an elongation parameter representative of an increment to be applied to a respective positioning parameter in order to obtain an actual length of a corresponding structural component in said finished tyre; a width parameter representative of a dimension, measured in the axial direction, of a tread band of said finished tyre.

9. Method according to any one of the preceding claims, wherein said second parameters (P2) comprise one or more of: a positioning parameter of a forming drum used for building the green tyre; a distance parameter for each one of the structural components of said carcass sleeve (100).

10. Method according to any one of the preceding claims, comprising:

   activating said processor for retrieving, from said memory (M), a second mathematical model (MM2);
   activating said processor (10) for computing said second parameters (P2) starting from said first parameters (P1) by applying said second mathematical model (MM2)
   activating said processor for retrieving, from said memory (M), a third mathematical model (MM3);
   activating said processor (10) for computing said third parameters (P3) starting from said first parameters (P1) by applying said third mathematical model (MM3).

11. Plant for the production of tyres, comprising:

   one or more operating apparatuses (30; 40, 41; 50, 51) adapted to build a green tyre, a finished tyre being obtained from said green tyre through at least a moulding and curing process;
   a processing unit (70) configured for:

      determining first parameters (P1) describing said finished tyre;
      computing, as a function of said first parameters (P1), second parameters (P2) describing a carcass sleeve (100) and third parameters (P3) describing a crown sleeve (110), said carcass sleeve (100) and said crown sleeve (110) being used for building said green tyre;
      wherein said second parameters (P2) comprise at least one parameter representative of an outer diameter (D1) of said carcass sleeve (100);
      wherein said third parameters (P3) comprise at least one parameter representative of an inner diameter (D2) of said crown sleeve (110);
      retrieving, from a memory (M), a first mathematical model (MM1) describing a process of shaping said carcass sleeve (100) when the latter is shaped to adhere to the radially inner surface of said crown sleeve (110), for obtaining said green tyre;
computing, as a function of said second parameters (P2), said third parameters (P3) and said first mathematical model (MM1), one or more operating parameters (OP) for the execution of a building process for building said green tyre;

wherein said one or more operating parameters (OP) comprise at least one parameter associated with an axial dimension of said green tyre;
wherein said first mathematical model (MM1) puts the axial dimension of said green tyre in relation with a difference between the inner diameter (D2) of said crown sleeve (110) and the outer diameter (D1) of said carcass sleeve (100);
wherein said processing unit (70) is configured for controlling, as a function of said one or more operating parameters (OP), said one or more operating apparatuses (30; 40, 41; 50, 51) adapted to build said green tyre.

12. Plant according to claim 11, wherein said one or more operating apparatuses comprise a shaping apparatus (30) configured for shaping said carcass sleeve (100) by inflation and for bringing axial ends (101, 102) of said carcass sleeve (100) near each other.

13. Plant according to claim 11, wherein said one or more operating apparatuses comprise one or more rollers (40) and associated drive units (41)
wherein said one or more operating apparatuses comprise at least one distribution unit (50) for distributing a given substance/semifinished product, and associated drive units (51).

14. Electronic unit associable with one or more operating apparatuses (30; 40, 41; 50, 51) adapted to build a green tyre, a finished tyre being obtained from said green tyre through at least a moulding and curing process, said electronic unit (80) being configured for:

   determining first parameters (P1) describing said finished tyre;
   computing, as a function of said first parameters (P1), second parameters (P2) describing a carcass sleeve (100) and third parameters (P3) describing a crown sleeve (110), said carcass sleeve (100) and said crown sleeve (110) being used for building said green tyre;
   wherein said second parameters (P2) comprise at least one parameter representative of an outer diameter (D1) of said carcass sleeve (100);

wherein said third parameters (P3) comprise at least one parameter representative of an inner diameter (D2) of said crown sleeve (110);

retrieving, from a memory (M), a first mathematical model (MM1) describing a process of shaping said carcass sleeve (100) when the latter is shaped to adhere to the radially inner surface of said crown sleeve (110), for obtaining said green tyre;

computing, as a function of said second parameters (P2), said third parameters (P3) and said first mathematical model (MM1), one or more operating parameters (OP) for the execution of a building process for building said green tyre;

wherein said one or more operating parameters (OP) comprise at least one parameter associated with an axial dimension of said green tyre;

wherein said first mathematical model (MM1) puts the axial dimension of said green tyre in relation with a difference between the inner diameter (D2) of said crown sleeve (110) and the outer diameter (D1) of said carcass sleeve (100);

wherein said electronic unit (80) is configured for generating output signals (OS) incorporating said one or more operating parameters (OP).

15. Processing unit comprising an electronic unit (80) according to the preceding claim, wherein said processing unit (70) is also configured for controlling, as a function of said one or more operating parameters (OP), said one or more operating apparatuses (30; 40, 41; 50, 51) for the execution of said building process.


**Patentansprüche**

1. Verfahren zur Steuerung eines Reifenproduktionsprozesses, wobei ein fertiger Reifen aus einem Rohreifen durch zumindest einen Formungs- und Vulkanisierprozess erhalten wird, umfassend:

Bestimmen von Parametern (P1), die den fertigen Reifen beschreiben;

Aktivieren eines Prozessors (10) zum Berechnen von zweiten Parametern (P2), die eine Karkassenhülle (100) beschreiben, und von dritten Parametern (P3), die eine Laufstreifenhülle (110) beschreiben, als eine Funktion der ersten Parameter (P1), wobei die Karkassenhülle (100) und die Laufstreifenhülle (110) zur Fertigung des Rohreifens verwendet werden;

wobei die zweiten Parameter (P2) zumindest einen Parameter umfassen, der einen äußeren Durchmesser (D1) der Karkassenhülle (100) repräsentiert;

wobei die dritten Parameter (P3) zumindest einen Parameter umfassen, der einen inneren Durchmesser (D2) der Laufstreifenhülle (110) repräsentiert;

Abfragen, durch den Prozessor (10), aus einem Speicher (M), der dem Prozessor (10) zugeordnet ist, eines ersten mathematischen Modells (MM1), das einen Prozess zum Formen der Karkassenhülle (100) beschreibt, wenn letztere so geformt wird, dass sie an einer radial inneren Oberfläche der Laufstreifenhülle (110) anhaftet, um den Rohreifen zu erhalten;

Aktivieren des Prozessors (10) zum Berechnen eines oder mehrerer Arbeitsparameter (OP) für die Ausführung eines Fertigungsprozesses zur Fertigung des Rohreifens als eine Funktion der zweiten Parameter (P2), der dritten Parameter (P3) und des ersten mathematischen Modells (MM1);

wobei der eine oder die mehreren Arbeitsparameter (OP) zumindest einen Parameter umfassen, der einer axialen Dimension des Rohreifens zugeordnet ist;

wobei das erste mathematische Modell (MM1) die axiale Dimension des Rohreifens in Beziehung zu einer Differenz zwischen dem inneren Durchmesser (D2) der Laufstreifenhülle (110) und dem äußeren Durchmesser (D1) der Karkassenhülle (100) setzt;

Erfassen, durch eine Steuervorrichtung (20), des einen oder der mehreren Arbeitsparameter (OP) und Steuern eines oder mehrerer Arbeitseinrichtungen (30; 40, 41; 50, 51) zur Ausführung des Fertigungsprozesses.

2. Verfahren nach Anspruch 1, wobei der Fertigungsprozess einen Formungsprozess umfasst, wobei die eine oder die mehreren Arbeitseinrichtungen eine Formungseinrichtung (30) umfassen, die dazu ausgestaltet ist, die Karkassenhülle (100) durch Aufblasen zu formen, und die axialen Enden (101, 102) der Karkassenhülle (100) nahe zueinander zu bringen.

3. Verfahren nach Anspruch 2, wobei der eine oder die mehreren Arbeitsparameter (OP) einen oder mehrere Parameter umfassen, die einen Druck beschreiben, der auf die Karkassenhülle (100) zum Aufblasen aufgebracht werden soll, sowie einen oder mehrere Parameter, die ein Annäherungsprofil der axialen Enden (101, 102) der Karkassenhülle (100) beschreiben.

4. Verfahren nach einem der vorhergehenden Ansprüche, wobei der Fertigungsprozess einen Extrusionsprozess zum Erhalten eines oder mehrerer struktureller Komponenten des Rohreifens durch jeweilige Düsen umfasst,

wobei das Verfahren das Berechnen eines oder mehrerer Identifizierungsparameter (IP), die eine oder mehrere Düsen beschreiben, die für den Extrusionsprozess verwendet werden sollen, als eine Funktion der zweiten Parameter (P2), der dritten Parameter (P3) und des ersten mathematischen Modells (MM1) umfasst, wobei das Verfahren umfasst:

➢ Vergleichen der Identifizierungsparameter (IP) mit einem oder mehreren Referenzparametern (RP), wobei der eine oder die mehreren Referenzparameter (RP) Düsen beschreiben, welche zuvor zur Herstellung struktureller Komponenten verwendet wurden;

➢ Ausgeben eines Bestätigungssignals (CS), wenn der eine oder die mehreren Referenzparametern (RP) den Identifizierungsparametern (IP) entsprechen.

5. Verfahren nach Anspruch 4, das, wenn der eine oder die mehreren Referenzparameter (RP) nicht den Identifizierungsparametern (IP) entsprechen:

➢ Bestimmen einer Differenz zwischen den Düsen, die durch die Identifizierungsparameter (IP) identifiziert wurden, und den Düsen, die den Referenzparametern (RP) zugeordnet sind, auf Grundlage eines vordefinierten Messsystems;

➢ Bestimmen einer oder mehrerer Düsen, die den Referenzparametern (RP) zugeordnet sind, für die die Differenz geringer als eine gegebene Schwelle ist;

➢ Berechnen von Parametern, welche einen alternativen Rohreifen beschreiben, der mittels der bestimmten Düsen erhalten wird;

➢ Erzeugen einer Ausgabe, welche den alternativen Rohreifen beschreibt.

6. Verfahren nach einem der vorhergehenden Ansprüche, umfassend das Aktivieren des Prozessors (10) zum Berechnen eines oder mehrerer Ausgabeparameter (Pout) für die Ausführung eines Herstellungsprozesses an dem Rohreifen als eine Funktion der zweiten Parameter (P2), der dritten Parameter (P3) und des ersten mathematischen Modells (MM1),

wobei der eine oder die mehreren Ausgabeparameter (Pout) die axiale Dimension des Rohreifens umfassen,

wobei der Herstellungsprozess einen Formungs- und Vulkanisierprozess umfasst.

7. Verfahren nach einem der vorhergehenden Ansprüche, wobei das Bestimmen der ersten Parameter das Empfangen der ersten Parameter (P1) umfasst,

wobei die ersten Parameter (P1) während eines Dateneingabeschritts fortlaufend von einem Benutzer eingegeben werden,

wobei, während des Dateneingabeschritts, die ersten Parameter (P1) Parameter (P11) umfassen, die bereits eingegeben wurden, sowie Parameter (P12), die noch einzugeben sind, wobei das Verfahren das Aktivieren des Prozessors (10) zum Bereitstellen von vorgeschlagenen Werten (SV) für die Parameter (P12), die noch einzugeben sind, umfasst, wobei die vorgeschlagenen Werte (SV) als eine Funktion der Parameter (P11), die bereits eingegeben wurden, bestimmt werden.

8. Verfahren nach einem der vorhergehenden Ansprüche, wobei die ersten Parameter (P1) einen oder mehrere der folgenden umfassen: einen Pass-Parameter; einen oder mehrere Parameter, die den Typ der strukturellen Komponenten des fertigen Reifens repräsentieren; einen oder mehrere Parameter, welche die Anzahl für jeden Typ der strukturellen Komponenten des fertigen Reifens repräsentieren; einen Parameter, der eine Höhe eines Fülleinsatzes des fertigen Reifens repräsentiert; einen Dehnungsparameter, der ein Inkrement repräsentiert, das auf einen jeweiligen Positionierungsparameter anzuwenden ist, um eine tatsächliche Länge einer strukturellen Komponente in dem fertigen Reifen zu erhalten; einen Breitenparameter, der eine Dimension eines Laufflächenrings des fertigen Reifens gemessen in der axialen Richtung repräsentiert.

9. Verfahren nach einem der vorhergehenden Ansprüche, wobei die zweiten Parameter (S2) einen oder mehrere der folgenden umfassen: einen Positionierungsparameter einer Formungstrommel, die zur Fertigung des Rohreifens verwendet wird; einen Abstandsparameter für jeden der strukturellen Komponenten der Karkassenhülle (100).

10. Verfahren nach einem der vorhergehenden Ansprüche, umfassend:

Aktivieren des Prozessors zum Abrufen eines zweiten mathematischen Modells (MM2) aus dem Speicher (M);
Aktivieren des Prozessors (10) zum Berechnen der zweiten Parameter (P2) ausgehend von den ersten Parametern (P1) durch Anwenden des zweiten mathematischen Modells (MM2),
Aktivieren des Prozessors zum Abrufen eines dritten mathematischen Modells (MM3) aus dem Speicher (M);
Aktivieren des Prozessors (10) zum Berechnen der dritten Parameter (P3) ausgehend von den ersten Parametern (P1) durch Anwenden des dritten mathematischen Modells (MM3).

**11.** Anlage für die Produktion von Reifen, umfassend:

eine oder mehrere Arbeitseinrichtungen (30; 40, 41; 50, 51), die dazu geeignet sind, Rohreifen zu fertigen, wobei ein fertiger Reifen aus dem Rohreifen durch zumindest einen Formungs- und Vulkanisierprozess erhalten wird;

eine Steuereinheit (70), die dazu ausgestaltet ist:

Parameter (P1) zu bestimmen, die den fertigen Reifen beschreiben;

als eine Funktion der ersten Parameter (P1) zweite Parameter (P2) zu berechnen, die eine Karkassenhülle (100) beschreiben, sowie dritte Parameter (P3), die eine Laufstreifenhülle (110) beschreiben, wobei die Karkassenhülle (100) und die Laufstreifenhülle (110) zur Fertigung des Rohreifens verwendet werden;

wobei die zweiten Parameter (P2) zumindest einen Parameter umfassen, der einen äußeren Durchmesser (D1) der Karkassenhülle (100) repräsentiert;

wobei die dritten Parameter (P3) zumindest einen Parameter umfassen, der einen inneren Durchmesser (D2) der Laufstreifenhülle (110) repräsentiert;

aus einem Speicher (M) ein erstes mathematisches Modell (MM1) abzurufen, das einen Prozess zum Formen der Karkassenhülle (100) beschreibt, wenn letztere so geformt wird, dass sie an einer radial inneren Oberfläche der Laufstreifenhülle (110) anhaftet, um den Rohreifen zu erhalten;

als eine Funktion der zweiten Parameter (P2), der dritten Parameter (P3) und des ersten mathematischen Modells (MM1), einen oder mehrere Arbeitsparameter (OP) für die Ausführung eines Fertigungsprozesses zur Fertigung des Rohreifens zu berechnen;

wobei der eine oder die mehreren Arbeitsparameter (OP) zumindest einen Parameter umfassen, der einer axialen Dimension des Rohreifens zugeordnet ist;

wobei das erste mathematische Modell (MM1) die axiale Dimension des Rohreifens in Beziehung zu einer Differenz zwischen dem inneren Durchmesser (D2) der Laufstreifenhülle (110) und dem äußeren Durchmesser (D1) der Karkassenhülle (100) setzt;

wobei die Verarbeitungseinheit (70) dazu ausgestaltet ist, als eine Funktion des einen oder der mehreren Arbeitsparameter (OP) die eine oder die mehreren Arbeitseinrichtungen (30; 40, 41; 50, 51) zu steuern, die dazu geeignet sind, den Rohreifen zu fertigen.

**12.** Anlage nach Anspruch 11, wobei die eine oder die mehreren Arbeitseinrichtungen eine Formungseinrichtung (30) umfassen, die dazu ausgestaltet ist, die Karkassenhülle (100) durch Aufblasen zu formen, und die axialen Enden (101, 102) der Karkassenhülle (100) nahe zueinander zu bringen.

**13.** Anlage nach Anspruch 11, wobei die eine oder die mehreren Arbeitseinrichtungen eine oder mehrere Rollen (40) und zugehörige Antriebseinheiten (41) umfassen,

wobei die eine oder die mehreren Arbeitseinrichtungen zumindest eine Ausgabeeinheit (50) zum Ausgeben einer gegebenen Substanz / eines gegebenen halbfertigen Produkts sowie zugehörige Antriebseinheiten (51) umfassen.

**14.** Elektronische Einheit, die einer oder mehreren Arbeitseinrichtungen (30; 40, 41; 50, 51) zuordenbar ist, die dazu geeignet sind, Rohreifen zu fertigen, wobei ein fertiger Reifen aus dem Rohreifen durch zumindest einen Formungs- und Vulkanisierprozess erhalten wird, wobei die elektronische Einheit (80) dazu ausgestaltet ist:

Parameter (P1) zu bestimmen, die den fertigen Reifen beschreiben;

als eine Funktion der ersten Parameter (P1) zweite Parameter (P2) zu berechnen, die eine Karkassenhülle (100) beschreiben, sowie dritte Parameter (P3), die eine Laufstreifenhülle (110) beschreiben, wobei die Karkassenhülle (100) und die Laufstreifenhülle (110) zur Fertigung des Rohreifens verwendet werden;

wobei die zweiten Parameter (P2) zumindest einen Parameter umfassen, der einen äußeren Durchmesser (D1) der Karkassenhülle (100) repräsentiert;

wobei die dritten Parameter (P3) zumindest einen Parameter umfassen, der einen inneren Durchmesser (D2) der Laufstreifenhülle (110) repräsentiert;

aus einem Speicher (M) ein erstes mathematisches Modell (MM1) abzurufen, das einen Prozess zum Formen der Karkassenhülle (100) beschreibt, wenn letztere so geformt wird, dass sie an einer radial inneren Oberfläche der Laufstreifenhülle (110) anhaftet, um den Rohreifen zu erhalten;

als eine Funktion der zweiten Parameter (P2), der dritten Parameter (P3) und des ersten mathematischen Modells (MM1), einen oder mehrere Arbeitsparameter (OP) für die Ausführung eines Fertigungsprozesses zur Fertigung des Rohreifens zu berechnen;

wobei der eine oder die mehreren Arbeitsparameter (OP) zumindest einen Parameter umfassen, der einer axialen Dimension des Rohreifens zugeordnet ist;

wobei das erste mathematische Modell (MM1) die axiale Dimension des Rohreifens in Beziehung zu einer Differenz zwischen dem inneren Durchmesser (D2) der Laufstreifenhülle (110) und dem äußeren Durchmesser (D1) der Karkassenhülle (100) setzt;

wobei die elektronische Einheit (80) dazu ausgestaltet ist, Ausgabesignale (OS) zu erzeugen, die den einen oder die mehreren Arbeitsparameter (OP) einbeziehen.

15. Verarbeitungseinheit, umfassend eine elektronische Einheit (80) nach dem vorhergehenden Anspruch, wobei die Verarbeitungseinheit (70) auch dazu ausgestaltet ist, als eine Funktion des einen oder der mehreren Arbeitsparameter (OP) die eine oder die mehreren Arbeitseinrichtungen (30; 40, 41; 50, 51) für die Ausführung des Fertigungsprozesses zu steuern.

**Revendications**

1. Procédé de commande d'un processus de production de pneu, dans lequel un pneu fini est obtenu à partir d'un pneu cru par au moins un processus de moulage et de vulcanisation, comprenant le fait :

de déterminer des premiers paramètres (P1) décrivant ledit pneu fini ;

d'activer un processeur (10) pour calculer, en fonction desdits premiers paramètres (P1), des deuxièmes paramètres (P2) décrivant un manchon de carcasse (100) et des troisièmes paramètres (P3) décrivant un manchon de sommet (110), ledit manchon de carcasse (100) et ledit manchon de sommet (110) étant utilisés pour construire ledit pneu cru ;

dans lequel lesdits deuxièmes paramètres (P2) comprennent au moins un paramètre représentant un diamètre externe (D1) dudit manchon de carcasse (100) ;

dans lequel lesdits troisièmes paramètres (P3) comprennent au moins un paramètre représentant un diamètre interne (D2) dudit manchon de sommet (110) ;

par ledit processeur (10), d'extraire d'une mémoire (M) associée audit processeur (10) un premier modèle mathématique (MM1) décrivant un processus de mise en forme dudit manchon de carcasse (100) lorsque celui-ci est mis en forme pour adhérer à la surface radialement interne dudit manchon de sommet (110), pour obtenir ledit pneu cru ;

d'activer ledit processeur (10) pour calculer, en fonction desdits deuxièmes paramètres (P2), desdits troisièmes paramètres (P3) et dudit premier modèle mathématique (MM1), un ou plusieurs paramètre(s) de fonctionnement (OP) pour l'exécution d'un processus de construction pour construire ledit pneu cru ;

dans lequel ledit ou lesdits plusieurs paramètre(s) de fonctionnement (OP) comprend/comprennent au moins un paramètre associé à une dimension axiale dudit pneu cru ;

dans lequel ledit premier modèle mathématique (MM1) met la dimension axiale dudit pneu cru en relation avec une différence entre le diamètre interne (D2) dudit manchon de sommet (110) et le diamètre externe (D1) dudit manchon de carcasse (100) ;

par un dispositif de commande (20), d'acquérir ledit ou lesdits plusieurs paramètre(s) de fonctionnement (OP) et de commander un ou plusieurs appareil(s) fonctionnel(s) (30 ; 40, 41 ; 50, 51) pour exécuter ledit processus de construction.

2. Procédé selon la revendication 1, dans lequel ledit processus de construction comprend un processus de mise en forme, ledit ou lesdits plusieurs appareil(s) fonctionnel(s) comprenant un appareil de mise en forme (30) configuré pour mettre en forme ledit manchon de carcasse (100) par gonflage et pour rapprocher des extrémités axiales (101, 102) dudit manchon de carcasse (100) l'une de l'autre.

3. Procédé selon la revendication 2, dans lequel ledit ou lesdits plusieurs paramètre(s) de fonctionnement (OP) comprend/comprennent un ou plusieurs paramètre(s) décrivant une pression à appliquer audit manchon de carcasse (100) pour ledit gonflage et un ou plusieurs paramètre(s) décrivant un profil d'approche des extrémités axiales (101, 102) dudit manchon de carcasse (100).

4. Procédé selon l'une quelconque des revendications précédentes, dans lequel ledit processus de construction comprend un processus d'extrusion pour obtenir, par des buses respectives, un ou plusieurs composant(s) de structure dudit pneu cru.

le procédé comprenant le fait de calculer, en fonction desdits deuxièmes paramètres (P2), desdits troisièmes paramètres (P3) et dudit premier modèle mathématique (MM1), un ou plusieurs paramètre(s) d'identification (IP) décrivant une ou plusieurs buse(s) à utiliser pour ledit processus d'extrusion
le procédé comprenant le fait :

➢ de comparer lesdits paramètres d'identification (IP) à un ou plusieurs paramètre(s) de référence (RP), ledit ou lesdits plusieurs paramètre(s) de référence (RP) décrivant des buses précédemment utilisées pour fabriquer des composants de structure ;

➢ de délivrer en sortie un signal de confirmation (CS), si ledit ou lesdits plusieurs paramètre(s) de référence (RP) correspond/correspondent auxdits paramètres d'identification (IP).

5. Procédé selon la revendication 4, comprenant, si ledit ou lesdits plusieurs paramètre(s) de référence (RP) ne correspond/correspondent pas auxdits paramètres d'identification (IP), le fait :

➢ de déterminer, sur la base d'un système de mesure prédéfini, une différence entre les buses identifiées par lesdits paramètres d'identification (IP) et les buses associées auxdits paramètres de référence (RP) ;
➢ de déterminer une ou plusieurs buse(s) associée(s) auxdits paramètres de référence (RP), pour laquelle/lesquelles ladite différence est inférieure à un seuil donné ;
➢ de calculer des paramètres décrivant un pneu cru alternatif obtenu au moyen desdites buses déterminées ;
➢ de générer une sortie décrivant ledit pneu cru alternatif.

6. Procédé selon l'une quelconque des revendications précédentes, comprenant le fait d'activer ledit processeur (10) pour calculer, en fonction desdits deuxièmes paramètres (P2), desdits troisièmes paramètres (P3) et dudit premier modèle mathématique (MM1), un ou plusieurs paramètre(s) de sortie (Pout) pour l'exécution d'un processus de fabrication sur ledit pneu cru, où ledit ou lesdits plusieurs paramètre(s) de sortie (Pout) comprend/comprennent la dimension axiale dudit pneu cru
dans lequel ledit processus de fabrication comprend un processus de moulage et de vulcanisation.

7. Procédé selon l'une quelconque des revendications précédentes, dans lequel la détermination desdits premiers paramètres comprend la réception desdits premiers paramètres (P1)

dans lequel lesdits premiers paramètres (P1) sont progressivement entrés par un utilisateur pendant une étape d'entrée de données.
dans lequel, pendant ladite étape d'entrée de données, lesdits premiers paramètres (P1) comprennent des paramètres déjà entrés (P11) et des paramètres n'ayant pas encore été entrés (P12), où ledit procédé comprend le fait d'activer ledit processeur (10) pour fournir des valeurs suggérées (SV) pour lesdits paramètres n'ayant pas encore été entrés (P12), lesdites valeurs suggérées (SV) étant déterminées en fonction desdits paramètres déjà entrés (P11).

8. Procédé selon l'une quelconque des revendications précédentes, dans lequel lesdits premiers paramètres (P1) comprennent un ou plusieurs paramètre(s) parmi : un paramètre de montage ; un ou plusieurs paramètre(s) représentant le type de composants de structure du pneu fini ; un ou plusieurs paramètre(s) représentant le nombre de composants de structure, pour chaque type, du pneu fini ; un paramètre représentant une hauteur d'un insert de remplissage du pneu fini ; un paramètre d'allongement représentant un incrément à appliquer à un paramètre de positionnement respectif afin d'obtenir une longueur réelle d'un composant de structure correspondant dans ledit pneu fini ; un paramètre de largeur représentant une dimension, mesurée dans la direction axiale, d'une bande de roulement dudit pneu fini.

9. Procédé selon l'une quelconque des revendications précédentes, dans lequel lesdits deuxièmes paramètres (P2) comprennent un ou plusieurs paramètre(s) parmi : un paramètre de positionnement d'un tambour de formation utilisé pour construire le pneu cru ; un paramètre de distance pour chacun des composants de structure dudit manchon de carcasse (100).

10. Procédé selon l'une quelconque des revendications précédentes, comprenant le fait :

d'activer ledit processeur pour extraire, de ladite mémoire (M), un deuxième modèle mathématique (MM2) ;
d'activer ledit processeur (10) pour calculer lesdits deuxièmes paramètres (P2) à partir desdits premiers paramètres (P1) en appliquant ledit deuxième modèle mathématique (MM2)
d'activer ledit processeur pour extraire, de ladite mémoire (M), un troisième modèle mathématique (MM3) ;
d'activer ledit processeur (10) pour calculer lesdits troisièmes paramètres (P3) à partir desdits premiers paramètres (P1) en appliquant ledit troisième modèle mathématique (MM3).

11. Installation pour la production de pneus comprenant :

un ou plusieurs appareil (s) fonctionnel(s) (30 ; 40, 41 ; 50, 51) adapté(s) pour construire un pneu cru, un pneu fini étant obtenu à partir dudit pneu cru par au moins un processus de moulage et de vulcanisation ;

une unité de traitement (70) configurée pour :

déterminer des premiers paramètres (P1) décrivant ledit pneu fini ;

calculer, en fonction desdits premiers paramètres (P1), des deuxièmes paramètres (P2) décrivant un manchon de carcasse (100) et des troisièmes paramètres (P3) décrivant un manchon de sommet (110), ledit manchon de carcasse (100) et ledit manchon de sommet (110) étant utilisés pour construire ledit pneu cru ;

dans laquelle lesdits deuxièmes paramètres (P2) comprennent au moins un paramètre représentant un diamètre externe (D1) dudit manchon de carcasse (100) ;

dans laquelle lesdits troisièmes paramètres (P3) comprennent au moins un paramètre représentant un diamètre interne (D2) dudit manchon de sommet (110) ;

extraire, d'une mémoire (M), un premier modèle mathématique (MM1) décrivant un processus de mise en forme dudit manchon de carcasse (100) lorsque celui-ci est mis en forme pour adhérer à la surface radialement interne dudit manchon de sommet (110), pour obtenir ledit pneu cru ;

calculer, en fonction desdits deuxièmes paramètres (P2), desdits troisièmes paramètres (P3) et dudit premier modèle mathématique (MM1), un ou plusieurs paramètre(s) de fonctionnement (OP) pour l'exécution d'un processus de construction pour construire ledit pneu cru ;

dans laquelle ledit ou lesdits plusieurs paramètre(s) de fonctionnement (OP) comprend/comprennent au moins un paramètre associé à une dimension axiale dudit pneu cru ;

dans laquelle ledit premier modèle mathématique (MM1) met la dimension axiale dudit pneu cru en relation avec une différence entre le diamètre interne (D2) dudit manchon de sommet (110) et le diamètre externe (D1) dudit manchon de carcasse (100) ;

dans laquelle ladite unité de traitement (70) est configurée pour commander, en fonction dudit ou desdits plusieurs paramètre(s) de fonctionnement (OP), ledit ou lesdits plusieurs appareil(s) fonctionnel(s) (30 ; 40, 41 ; 50, 51) adapté(s) pour construire ledit pneu cru.

**12.** Installation selon la revendication 11, dans laquelle ledit ou lesdits plusieurs appareil(s) fonctionnel(s) comprend/comprennent un appareil de mise en forme (30) configuré pour mettre en forme ledit manchon de carcasse (100) par gonflage et pour rapprocher des extrémités axiales (101, 102) dudit manchon de carcasse (100) l'une de l'autre.

**13.** Installation selon la revendication 11, dans laquelle ledit ou lesdits plusieurs appareil(s) fonctionnel(s) comprend/comprennent un ou plusieurs rouleau(x) (40) et des unités d'entraînement associées (41) dans laquelle ledit ou lesdits plusieurs appareil(s) fonctionnel(s) comprend/comprennent au moins une unité de distribution (50) pour distribuer une substance/un produit semi-fini donné(e), et des unités d'entraînement associées (51) .

**14.** Unité électronique pouvant être associée à un ou plusieurs appareil(s) fonctionnel(s) (30 ; 40, 41 ; 50, 51) adapté(s) pour construire un pneu cru, un pneu fini étant obtenu à partir dudit pneu cru par au moins un processus de moulage et de vulcanisation, ladite unité électronique (80) étant configurée pour :

déterminer des premiers paramètres (P1) décrivant ledit pneu fini ;

calculer, en fonction desdits premiers paramètres (P1), des deuxièmes paramètres (P2) décrivant un manchon de carcasse (100) et des troisièmes paramètres (P3) décrivant un manchon de sommet (110), ledit manchon de carcasse (100) et ledit manchon de sommet (110) étant utilisés pour construire ledit pneu cru ;

dans laquelle lesdits deuxièmes paramètres (P2) comprennent au moins un paramètre représentant un diamètre externe (D1) dudit manchon de carcasse (100) ;

dans laquelle lesdits troisièmes paramètres (P3) comprennent au moins un paramètre représentant un diamètre interne (D2) dudit manchon de sommet (110) ;

extraire, d'une mémoire (M), un premier modèle mathématique (MM1) décrivant un processus de mise en forme dudit manchon de carcasse (100) lorsque celui-ci est mis en forme pour adhérer à la surface radialement interne dudit manchon de sommet (110), pour obtenir ledit pneu cru ;

calculer, en fonction desdits deuxièmes paramètres (P2), desdits troisièmes paramètres (P3) et dudit premier modèle mathématique (MM1), un ou plusieurs paramètre(s) de fonctionnement (OP) pour l'exécution d'un processus de construction pour construire ledit pneu cru ;

dans laquelle ledit ou lesdits plusieurs paramètre(s) de fonctionnement (OP) comprend/comprennent au moins un paramètre associé à une dimension axiale dudit pneu cru ;

dans laquelle ledit premier modèle mathématique (MM1) met la dimension axiale dudit pneu cru en relation avec une différence entre le diamètre interne (D2) dudit manchon de sommet (110) et le diamètre externe (D1) dudit manchon de carcasse (100) ;
dans laquelle ladite unité électronique (80) est configurée pour générer des signaux de sortie (OS) incorporant ledit ou lesdits plusieurs paramètre(s) de fonctionnement (OP).

15. Unité de traitement comprenant une unité électronique (80) selon la revendication précédente, dans laquelle ladite unité de traitement (70) est également configurée pour commander, en fonction dudit ou desdits plusieurs paramètre(s) de fonctionnement (OP), ledit ou lesdits plusieurs appareil(s) fonctionnel(s) (30 ; 40, 41 ; 50, 51) pour l'exécution dudit processus de construction.

EP 3 655 242 B1

FIG. 1

FIG. 2

40

41

FIG. 3

51

50

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0205143 A1
- WO 2009068933 A1
- WO 2006033119 A